Europäisches Patentamt

European Patent Office

Office européen des brevets

(11) Publication number: **0 228 352**
**A2**

# (12) EUROPEAN PATENT APPLICATION

(21) Application number: **86830378.5**

(22) Date of filing: **18.12.86**

(51) Int. Cl.⁴: **C 30 B 33/00**
**C 30 B 29/28**

(30) Priority: **30.12.85 IT 4900085**

(43) Date of publication of application:
**08.07.87 Bulletin 87/28**

(84) Designated Contracting States:
**AT BE CH DE ES FR GB GR LI LU NL SE**

(71) Applicant: **CONSIGLIO NAZIONALE DELLE RICERCHE**
**Piazzale Aldo Moro, 7**
**I-00185 Roma (IT)**

(72) Inventor: **Antonini, Bruno**
**Via Fonteiana 85**
**I-00152 Rome (IT)**

**Balestrino, Giuseppe**
**Via Franco Sacchetti 104**
**I-00137 Rome (IT)**

**Lagomarsino, Stefano**
**Via Arnobio 11**
**I-00136 Rome (IT)**

**Paroli, Paolo**
**Via Zuccoli 67**
**I-00137 Rome (IT)**

**Tucciarone, Aldo**
**Via Montevideo 10**
**I-00198 Rome (IT)**

(74) Representative: **de Simone, Domenico et al**
**Ing. Barzanò & Zanardo Roma S.p.A. Via Piemonte 26**
**I-00187 Roma (IT)**

(54) Process for obtaining layers of different magnetic anisotropy properties in epitaxial films of magnetic garnets.

(57) A process for obtaining layers of different magnetic anisotropy properties in epitaxial films of magnetic garnets, in which process the film is subjected to a reducing treatment with the formation of parallel layers with different lattice parameters, between which layers a difference occurs in the orientation of the axis of spontaneous magnetization as a result of the magnetostriction effect. More particularly, by carrying out an annealing treatment in hydrogen on a garnet film having a positive magnetostriction constant the formation is obtained of a lower layer with spontaneous magnetization perpendicular to the film plane as well as of a surface layer whose spontaneous magnetization lies in the plane. Such structure can be directly applied to the production of magnetic bubble memories.

EP 0 228 352 A2

**Description**

PROCESS FOR OBTAINING LAYERS OF DIFFERENT MAGNETIC ANISOTROPY PROPERTIES IN EPITAXIAL FILMS OF MAGNETIC GARNETS

The present invention relates to a process for obtaining layers of different magnetic anisotropy properties in epitaxial films of magnetic garnets. More particularly, the present invention relates to a process for realizing parallel layers in films of magnetic garnets, which films show spontaneous magnetization axes differently oriented from one another with respect to the film plane, i.e. spontaneous magnetization axes alternately perpendicular and parallel to such plane.

It is well known that in the recent years epitaxial films of magnetic garnets have been increasingly applied in devices in the field of electronics, such as the field of magnetic bubble memories, the field of magneto-optic displays, for various components for microwave circuits and so on.

Some of such applications require the presence within the film of a number of layers having different magnetic anisotropy properties.

An example which is at the present time of remarkable importance is that of the garnet films employed for magnetic bubble memories which, according to their present embodiment, are formed by a lower layer corresponding to the mass or bulk of the film, with spontaneous magnetization perpendicular to the film plane (which is called in the following the "type I layer" or the " layer I") and by a thin surface layer whose spontaneous magnetization is parallel to that plane (which layer is called in the following the "type II layer" or "layer II"). Magnetic bubbles are contained within the layer I, whereas the layer II, which offers a preferential path for the closing of the magnetic fluxes inside the film, performs the function of preventing the so-called "hard" magnetic bubbles from forming within said layer I, such hard bubbles being of complex structure in the domain walls and having anomalous static and dynamic properties.

Films for magnetic bubbles are produced at the present time by growing garnet films of suitable composition and of magnetic anisotropy properties of the type I layer, i.e. with spontaneous magnetization perpendicular to the film plane,and then subjecting the same to the so-called ionic implantation treatment. A review of the developments of such technique is given for instance by P. Gerard in Thin Solid Films, 114, 3 (1984). Such treatment consists in subjecting the outside face of the film to implantation processes with ions of various sizes and energies, said processes being followed by some annealing treatments in oxigen or in air atmospheres at temperatures of some hundreds of Celsius degrees.

As a consequence of such procedure, the surface layer takes on the magnetic anisotropy properties of the layer II, i.e. a spontaneous magnetization in the film plane.

A numer of investigations carried out on such subject showed the nature of the physical processes by which the magnetic anisotropy properties become modified as a result of ionic implantation: the ionic bombardment causes in the implanted layer an increase in the lattice parameter with respect to the starting parameter value of the film, such increase amounting to about 1-2 %; as the substrate, the film and the implanted layer continue to be epitaxial, the implanted layer is subjected to an elastic compression strain in a direction parallel to the film plane ($\sigma > 0$). Moreover, as the magnetostriction constant ($\lambda$) of the garnet compositions normally employed is of negative value, such compressione gives a negative contribution (equal to $\frac{3}{2} \sigma\lambda$ ) to the uniaxial anisotropy constant ($K_u$) so that the condition

$$K_u < 2\pi M^2$$

(where M is the film magnetization) is satisfied, and the spontaneous magnetization in the implanted layer is consequently parallel to the film plane instead of being perpendicular to the same.

Annealing treatments normally carried out after the implantation process aim at recrystallizing the surface layer which is highly damaged by the ionic bombardment.

Said ionic implantation technique is the only method employed at the present time in the industry for the production of magnetic garnet films having the characteristic feature mentioned above, that is the presence of a surface layer having spontaneous magnetization parallel to the film plane. Nevertheless, such method involves very complex and costly procedure and equipment.

Accordingly, it is an object of the present invention to provide a method for obtaining different superimposed layers of different magnetic anisotropy properties in single crystal films of magnetic garnets, which method is very simple to carry out and does not require the employment of costly equipment.

It is a further object of the present invention that of realizing a process that can be employed according to the starting garnet film features both for obtaining surface layers of the type II superimposed on layers of the type I, as required at the present time for the production of magnetic bubble memories, and for obtaining surface layers of the type I superimposed on layers of the type II, and giving also in addition the possibility of realizing relative thicknesses of said layers variable within quite a wide range.

Within such context, it has been found (B. Antonini, C.D. Brandle, S. Lagomarsino, A. Paoletti, P. Paroli, A. Tucciarone, J. Appl. Phys. 55, 2179 (1984)) that suitable reducing treatments, for example annealing treatments in hydrogen atmospheres at temperatures higher than 450°C, give rise on some particular garnet films to a surface layer (which will be designed in the following as the "layer of the type R" or "layer R") having a lattice parameter lower than the values of the same in the remainder of the film.

Further studies in the field of the present invention resulted in a better definition of such phenomenon, by extending the observation of the same to the generality of films of magnetic garnets.

Thus it has been surprisingly found that, on continuing the reducing treatment, i.e. on increasing the temperatures and the annealing times, after a starting expansion of the lattice of the whole film in a more or less extended amount or even in a negligible amount, a shrinking of said lattice occurs starting from the most superficial layer towards the inside of the film. It was also possible to observe that the thickness of such layer R increases almost linearly with the time of the reducing treatment. For example, on annealing in hydrogen atmosphere at the temperature of 510°C, the observed increase in the thickness of the layer R is of about 0.2 μm for each hour of treatment. It is then possible to obtain in a very highly controlled way the formation of layers of the type R of very thin thicknesses, of the order of magnitude of $10^{-2}$ μm.

Further studies showed that neither the crystalline structure nor the magnetic structure of the layer R become damaged with respect to the starting structures of the film, contrarily to what observed in layers obtained by the conventional method of ionic implantation.

Such observations suggested the possibility of employing a reducing treatment for forming some layers having different lattice parameters within a magnetic garnet film, said layers having different magnetic anisotropy properties from one another as a result of the stress state and the magnetostriction effect stemming from the same.

Accordingly, the present invention consists in a process for obtaining in an epitaxial film of a magnetic garnet layers having different magnetic anisotropy properties, said process being characterized in that said film is subjected to a reducing treatment, so that the formation is obtained of layers having different lattice parameters and therefore the occurrence is obtained within said layers of magnetostriction phenomena.

In particular, said reduction treatment consists in an annealing treatment, so that the formation is obtained of two layers, of which the surface layer has a lattice parameter lower than the underlying layer.

According to a specific embodiment of the present invention, the starting magnetic garnet film has a positive magnetostriction constant, so as to obtain that the surface layer has a spontaneous magnetization in a direction parallel to the film plane, whereas the underlying layer has a spontaneous magnetization at right angles to the film plane.

Indeed, if the starting film in addition to being of the type I has a positive magnetostriction constant and the surface layer R, being of a shrinked lattice parameter, is under tensile stress ( $\sigma < 0$ ) the contribution to the uniaxial anisotropy constant for such layer is negative, and if the constant "$\lambda$" is of a sufficiently high absolute value, the spontaneous magnetization in the layer R is parallel to the film plane, i.e. a surface layer of the type II is obtained, whereas the remainder of the film keeps of the type I.

Alternatively, again according to the specific embodiment of the invention mentioned above, the starting film can have a magnetization parallel to the plane and said film can be such that the annealing treatment causes, as already mentioned above, first an expansion in the lattice of the whole mass of the film and then the well known shrinking of the layer R. In that case, the underlying layer becomes compressed ( $\sigma > 0$ ) and, as the magnetostriction constant $\lambda$ is positive, for sufficiently high values of the same, the condition
$$K_u > 2 \pi M^2$$
is satisfied, and therefore the spontaneous magnetization of the film mass turns out to be in a direction perpendicular to the film plane (layer of the type I). The layer R is subjected on the contrary to a negligible stress so that the spontaneous magnetization of that layer keeps parallel to the film plane (layer of the type II). A magnetic garnet of positive magnetostriction constant can be obtained, as is well known, by employing compositions containing a low amount of substitutions with some magnetic ions, such as for instance trivalent ruthenium or trivalent manganese; the introduction of such substituting ions can be carried out with no difficulties.

According to a further embodiment of the present invention the starting film of magnetic garnet has a negative magnetostriction constant, so that a surface layer is obtained having its spontaneous magnetization at right angles to the film plane whereas the underlying layer has its spontaneous magnetization parallel to that plane.

According to such embodiment of the invention, if the starting garnet is completely of the type II and the constant $\lambda$ is negative and of a sufficiently large absolute, value, the tensile stress induced in the surface layer R ($\sigma < 0$) causes a positive contribution to the constant $K_u$ so that the relationship:
$$K_u > 2 \pi M^2$$
is satisfied and as a consequence the layer R turns out to be of the type I.

According to the above disclosure, said layer R can be obtained as a layer of a few hundredths of μm thickness and with a degree of crystalline and magnetic perfection comparable to that of the starting film. According to the present state of knowledge about magnetic bubbles, a film of the type suggested above is capable of supporting magnetic bubbles having diameters of a few hundredths of μm. Such realization, which appears to be of a remarkable innovative purport, is very difficult to obtain employing the methods already known in the prior art.

According to the preferred embodiment of the present invention, the annealing treatment is carried out in hydrogen atmosphere at temperatures higher than 450°C, and, preferentially, not greater than 650°C. The total annealing time is comprised between 1 and 24 hrs, according to the required thickness of the surface layer. The correct total annealing time can be established by controlling the thickness of the layer R from time to time during the annealing treatment, and considering that, as already said, the thickness of such layer increases almost linearly with the time of the treatment.

The present invention will be disclosed in the following example for illustrative and not for limitative purposes, according to a specific embodiment of the invention itself.

EXAMPLE

The starting film of magnetic garnet has the crystallographic orientation (100) and a thickness of 10 μm; its chemical composition is given by the formula

$Y_{2.62}Ca_{0.23}La_{0.15}Ru_{0.05}Fe_{4.45}Ga_{0.5}O_{12}$,

the magnetization is

$4\pi M = 500 \ G$

and its lattice parameter is $a_0 = 12.381$ Å (i.e. such parameter is equal to that of the substrate of gadolinium and gallium garnet on which the film itself has been grown).

At the starting point, the uniaxial magnetic anisotropy constant of the film is almost zero, so that the shape magnetic anisotropy keeps the magnetization $\vec{M}$ parallel to the plane.

The film is subjected to a heat treatment of 4 hours in a hydrogen atmosphere at 540°C. Such treatment causes an expansion of the lattice parameter of the film, until it reaches the value $a_1 = 12.400$ Å. Because of the epitaxial relation with the substrate (whose lattice parameter has kept its value $a_0$) the film is caused to undergo an elastic compression; the elastic stress is given by

$$\sigma = \frac{a_1 - a_0}{a_0} \cdot \frac{E}{1+\mu} = 1.6 \times 10^{-3} \frac{2 \times 10^{12}}{1+0.3} = 2.46 \times 10^{9} \ erg \ cm^{-3}$$

$= 2.46 \times 10^9 \ erg \ cm^{-3}$

where $E = 2 \times 10^{12} erg \ cm^{-3}$ is the Young modulus, and $\mu = 0.3$ is the Poisson coefficient.

The presence in the composition of 0.05 ruthenium ions per unit formula gives the film a magnetostriction constant $\lambda_{100} = 1.1 \times 10^{-5}$. As a consequence the elastic stress σ causes a uniaxial magnetic anisotropy whose constant is given by

$K_u = \frac{3}{2} \sigma\lambda_{100} = 4 \times 10^{+4} \ erg \ cm^{-3}$

As $K_u > 2\pi M^2$, the spontaneous magnetization is in a direction perpendicular to the film plane.

The heat treatment mentioned above, in addition to an increase in the value of the lattice parameter of the garnet film, gives also rise to the formation of a surface layer of 1 μm tickness and lattice parameter $a_2 = 12.380$ A, i.e. a lattice parameter shrinked with respect to the value $a_1$ which is taken on the remainder of the film, and almost equal to the lattice parameter of the substrate. Because of the epitaxial relation with the remainder of the film and with the substrate, the elastic stress of the surface layer is almost null, so that the spontaneous magnetization of the surface layer turns out to be parallel to the film plane and at right angles to the magnetization of the remainder of the film as desired.

The present invention has been disclosed with particular reference to some of its specific embodiments, but it is to be understood that modifications and changes can be introduced in the same by those who are skilled in the art without departing from its true spirit and scope.

**Claims**

1. A process for obtaining layers of different magnetic anisotropy properties in an epitaxial film of a magnetic garnet, such process being characterized in that said film is subjected to a reducing treatment, so that the formation is obtained of layers of different lattice parameters and hence the arising within said layers of magnetostriction phenomena.

2. A process according to claim 1 wherein said reducing treatment consists in an annealing treatment, so that the formation is obtained of two layers, the superficial one having a lattice parameter of a lower value than the parameter of the underlying layer.

3. A process according to claim 2, wherein said film of magnetic garnet is chosen among the films having a positive magnetostriction constant, so that to obtain that said surface layer has a spontaneous magnetization parallel to the plane of said film, whereas said underlying layer has a spontaneous magnetization perpendicular to said plane.

4. A process according to claim 2, wherein said film of magnetic garnet is selected among those having a negative magnetostriction constant, so that to obtain that said surface layer has a spontaneous magnetization perpendicular to the plane of said film whereas said underlying layer has a spontaneous magnetization parallel to said plane.

5. A process according to each one of claims 2-4, wherein said annealing treatment is carried out in a hydrogen atmosphere at temperatures higher than 450°C.

6. A process according to claim 5 wherein said annealing treatment is carried out at a temperature comprised between 450°C and 650°C, for a total period of time between 1 and 24 hrs.